# EUROPÄISCHE PATENTANMELDUNG

(11) **EP 0 597 144 A1**
(43) Veröffentlichungstag der Anmeldung: **18.05.1994**
(21) Anmeldenummer: 92119327.2
(22) Anmeldetag: 12.11.1992
(51) Int. Cl.: H01L 25/16, H01L 23/538

(54) **Hybride leistungselektronische Anordnung**

(71) Anmelder: IXYS Semiconductor GmbH, D-68623 Lampertheim (DE)
(72) Erfinder: Bayerer, Reinhold, Dr., W-6101 Reichelsheim (DE)
(74) Vertreter: Rupprecht, Klaus, Dipl.-Ing.

(57) **Zusammenfassung**

Um eine kompakte, mit geringem Material- und Zeitaufwand herzustellende hybride leistungselektronische Anordnung zu erzielen, wird vorgeschlagen, ein Leistungsteil (9) der Anordnung aufzubauen, unter Verwendung einer Trägerplatte (10), die als Kühlkörper ausgebildet sein kann. Auf die Trägerplatte (10) ist eine Stapelanordnung (11) mit abwechselnd übereinander geschichteten Isoliermaterialschichten (12) und Leiterbahnschichten (13) angeordnet. Die Stapelanordnung (11) weist Ausschnitte (14) auf, in die gehäuselose Leistungshalbleitermodule (15) eingesetzt sind. Im Bereich der Ausschnitte (14) sind z.B. durch Stufung der Schichten (12,13) Anschlußflächen (27) geschaffen, die eine Herstellung von elektrischen Verbindungen zwischen den Leiterbahnschichten (13) und den Modulen (15) ermöglichen.

## Beschreibung

Die Erfindung bezieht sich auf eine hybride leistungselektronische Anordnung.

Eine solche Anordnung kann z.B. als Antriebssteuereinrichtung für einen Elektromotor oder als Schaltnetzteil Anwendung finden.

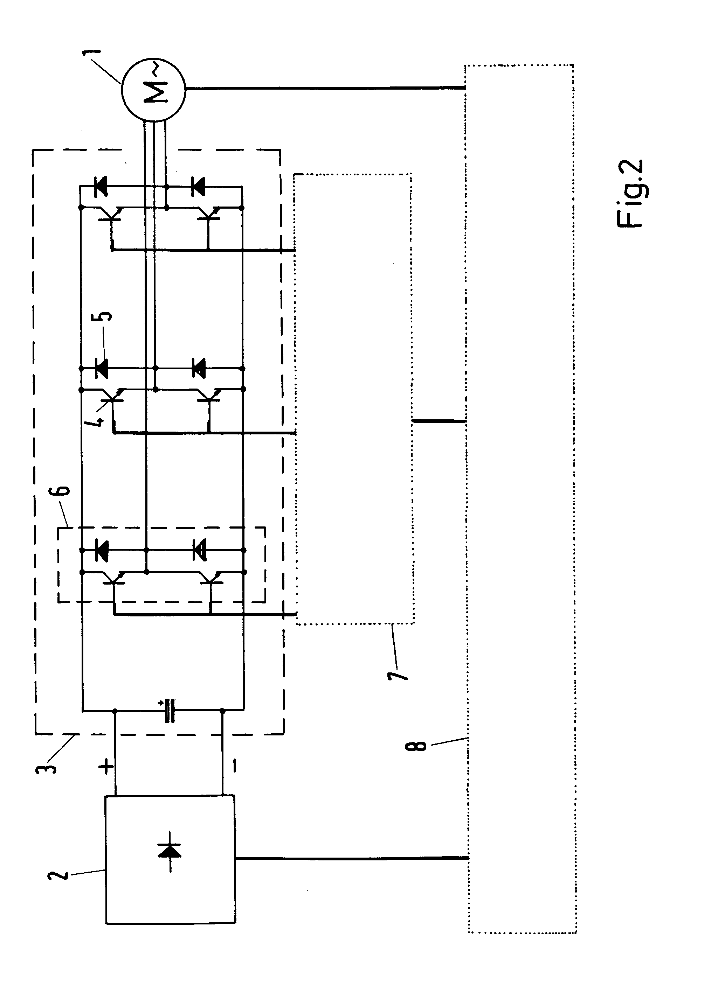

In Figur 2 ist beispielhaft die Schaltungsanordnung für eine Antriebssteuereinrichtung für einen Drehstrommotor 1 als Blockschema dargestellt. Die Schaltungsanordnung zeigt eine Wechselrichterschaltung zum Anschluß des Motors an ein Wechselspannungsnetz und zur Erzeugung einer Dreiphasen-Ausgangsspannung variabler Frequenz. In Figur 2 ist eine übliche Aufteilung in Komponenten dargestellt, die zur Realisierung der Anordnung durch Verschrauben, Löten oder Stecken miteinander verbunden werden. Die Leistungsteile, wie Gleichrichter 2 und Wechselrichter 3, bestehen entweder aus diskreten Leistungshalbleiterbauelementen, wie z.B. Leistungstransistoren 4 und Dioden 5, oder aus Leistungshalbleitermodulen, z.B. Teilbrükken 6, also integrierten oder hybriden Halbleiterkonfigurationen. Die zugehörige Ansteuerelektronik 7 und Regelelektronik 8 wird üblicherweise auf Leiterplatten aufgebracht und mit den Leistungskomponenten durch Schrauben, Stecken oder Löten verbunden.

Leistungshalbleitermodule, die für den Aufbau der Leistungsteile geeignet sind, sind z.B. aus der DE-PS 36 69 017 bekannt. Sie bestehen aus einer elektrisch isolierten Grundplatte, die im Inneren des Moduls Leistungshalbleiterchips trägt. Von diesen Chips sind Verbindungen zur Moduloberseite über Bonddrähte und gelötete Kupferlaschen bereitgestellt. Zum Schutz der Halbleiter befindet sich das Modul in einem Kunststoffgehäuse, das mit Vergußmassen vergossen ist. Das Gehäuse beinhaltet auch Befestigungslaschen zum Aufschrauben auf einen Quellkörper. Das Gehäuse muß einen hohen Anpreßdruck des Modulbodens zum Kühler hin ausüben, um einen guten Wärmeübergang über Wärmeleitpaste zum Kühler hin zu erlauben. Die verschiedenen Module zur Realisierung einer umfangreicheren Schaltung sind wiederum durch Stromschienen miteinander zu verbinden. Eine solche Schienen-Verbindung wird in einer zweiten Ebene vorgenommen, mit etwa 30 mm Abstand zu einem Kühler, um ausreichende Luft- und Kriechstrecken zur Sicherstellung der elektrischen Isolation zu erreichen. In der gleichen Ebene oder noch darüber schließen sich Beschaltungseinrichtungen und eine Elektronikplatine an.

Ein solcher bekannter Aufbau von Stromrichtergeräten einschließlich Schutzeinrichtungen und Ansteuerungselektronik erfordert einen hohen Materialaufwand und in der Montage zahlreiche Zwischenschritte sowie Schraub- und Montageschritte. Der Erfindung liegt die Aufgabe zugrunde, eine hybride leistungselektronische Anordnung in einer Kompaktbauweise anzugeben, die zu einer Einsparung an Material und Herstellkosten führt.

Diese Aufgabe wird gelöst durch eine hybride leistungselektronische Anordnung mit einem Leistungsteil der nachstehende Merkmale aufweist:
a) auf einer Trägerplatte ist eine Stapelanordnung mit abwechselnd übereinander angeordneten Isoliermaterialschichten und Leiterbahnschichten befestigt,
b) die Stapelanordnung weist mehrere Ausschnitte auf, in die gehäuselose Leistungshalbleitermodule eingesetzt sind, die aus einem elektrisch isolierenden Substrat mit Leiterbahnen und zumindest Halbleiterchips als Bestückungselemente bestehen,
c) die Ausschnitte sind treppenförmig gestuft oder es sind durch Ausnehmungen im Stapel oder auf andere Weise Anschlußflächen der Leiterbahnschichten zugänglich gemacht für den Anschluß elektrischer Verbindungsmittel bzw. zur Herstellung elektrischer Verbindungen zwischen den Modulen und Leiterbahnschichten oder zwischen Leiterbahnschichten untereinander.

Vorteilhafte Ausgestaltungen sind in den Patentansprüchen angegeben und der unten stehenden Beschreibung eines Ausführungsbeispiels zu entnehmen.

Die erfindungsgemäße Anordnung läßt sich weitgehend automatisiert herstellen und weist im Vergleich zu bekannten Stromrichtergeräten ein geringeres Gewicht und Volumen auf. Zahlreiche Zwischenverbindungen, Schraubverbindungen und Kapselungen entfallen. Es lassen sich unterschiedliche Technologien kombinieren und eine sowohl mechanisch als auch elektrisch robuste Anordnung erzielen. Vorteilhafte Ausgestaltungen beziehen sich besonders auf eine gute elektrische Abschirmung, eine geringe Streuinduktivität und eine hochwirksame Kühlung.

Eine detaillierte Beschreibung der Erfindung erfolgt nachstehend anhand eines in der Zeichnung dargestellten Ausführungsbeispiels. Es zeigen:
Figur 1 eine erfindungsgemäße Anordnung,
Figur 2 Stand der Technik: Schaltungsanordnung mit einer gemäß dem Stand der Technik üblichen Aufteilung in Realisierungskomponenten,
Figur 3 Schnittbild mit Detailldarstellung eines Moduls in der Anordnung nach Figur 1,
Figur 4 Schnittbild mit Detailldarstellung eines Ausschnitts in einer Stapelanordnung des Leistungsteils nach Figur 1,
Figur 5 Draufsicht auf einen Ausschnitt in der Stapelanordnung,
Figur 6 Darstellung einer Klemmtechnik zur Herstellung mechanisch elektrischer und thermischer Kontakte,
Figur 7 erfindungsgemäße Anordnung mit einer Ergänzung des Leistungsteils durch eine Elektronikschicht auf der Stapelanordnung.

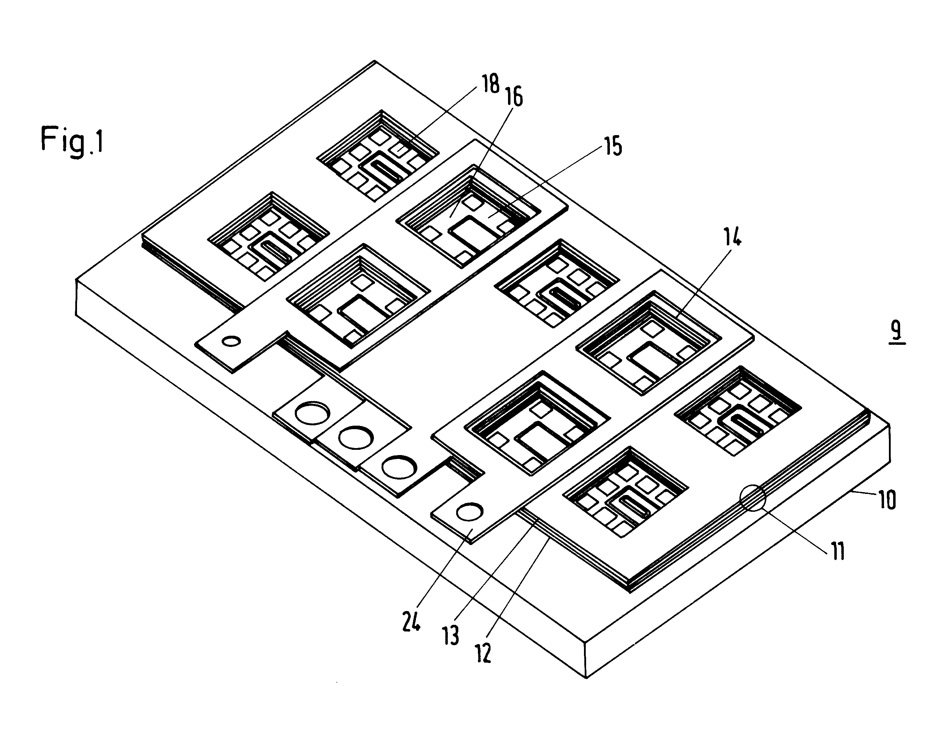

Figur 1 zeigt einen Leistungsteil 9 einer erfindungsgemäßen Anordnung. Er ist geeignet zur Steuerung von Strömen von einigen 100 A bis etwa 1000 A. Die Anordnung enthält eine Trägerplatte 10, die bevorzugt aus einem gut wärmeleitenden Material, z.B. einem Metall hergestellt werden kann.

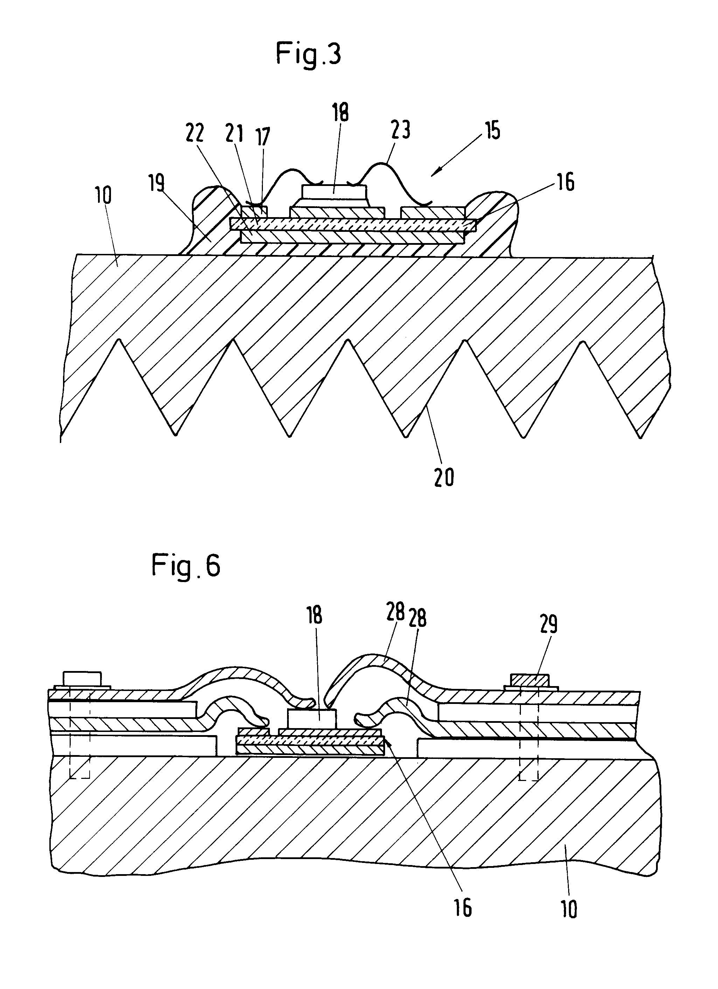

Auf der Trägerplatte 10 befindet sich eine Stapelanordnung 11, die aus mehreren abwechselnd übereinander geschichteten Isoliermaterialschichten 12 und metallischen Leiterbahnschichten 13 aufgebaut ist. Die Leiterbahnschichten 13 können als mehrere in einer Ebene liegende, nicht miteinander verbundene Leiterbahnen ausgeführt sein. Die Schichten 12, 13 sind vorzugsweise durch Kleben aufgebracht, wobei selbstklebende Isolierfolien besonders vorteilhaft verwendet werden können. Die Leiterbahnschichten 13 sind an geeigneten Stellen mit Anschlüssen 24 aus der Stapelanordnung herausgeführt um äußere Anschlüsse bereitzustellen. Die Stapelanordnung 11 weist mehrere Ausschnitte 14 auf, wodurch oben offene Räume geschaffen sind, in die Leistungshalbleitermodule 15 eingesetzt sind. Es handelt sich bei den Modulen 15 um Substrate 16, die z.B. aus Keramik bestehen und mit metallischen Leiterbahnen 17 (siehe Figur 3) versehen sind und die Bestückungselemente tragen. Solche Bestückungselemente sind Halbleiterchips 18, können aber auch Widerstände oder andere Bauelemente sein. Die Module 15 sind nicht durch sonst übliche Kunststoffgehäuse gekapselt, sondern als gehäuselose Hybridschaltungen auf die Trägerplatte 10 mit wärmeleitendem Klebstoff aufgeklebt, gelötet oder geklemmt.

Das Schnittbild Figur 3 zeigt im Detail ein auf den Träger 10 mit Hilfe eines wärmeleitenden Klebers 19 aufgeklebtes Modul 15. Die Trägerplatte 10 ist im dargestellten Beispiel als Kühlkörper mit Kühlrippen 20 ausgeführt. Eine andere günstige Ausführungsform der Trägerplatte 10 wäre z.B. ein Flüssigkeitskühler. Jedenfalls kann die Trägerplatte 10 sehr gut als integrierte Kühleinrichtung wirken.

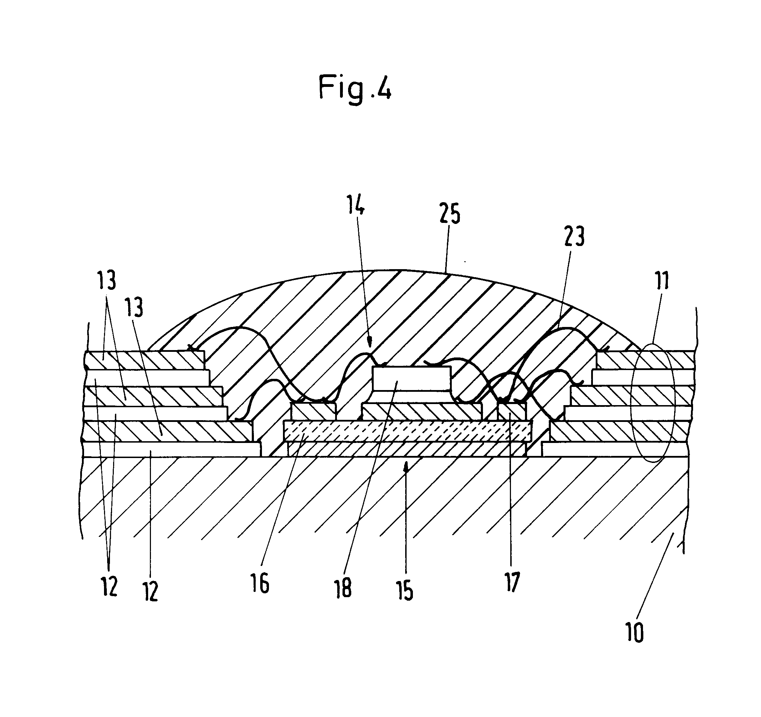

Das Modul 15 in Figur 3 enthält als Substrat 16 eine Keramikplatte 21, die auf der Unterseite, die der Trägerplatte 10 zugewandt ist, eine Kupferfolie 22 und auf der Oberseite Leiterbahnen 17 ebenfalls aus Kupfer aufweist. Die Kunststoffolie 22 bzw. die Leiterbahnen 17 sind vorzugsweise durch Anwendung eines Direktverbindungsverfahrens mit der Keramik verbunden. Auf solche Weise hergestellte Substrate weisen ein gutes Wärmeleitvermögen und hohe Lastwechselfestigkeit auf. Auf einer Leiterbahn 17 ist ein Halbleiterchip 18 aufgelötet, der im wesentlichen aus Silizium besteht. Elektrische Verbindungen zwischen den Leiterbahnen 17 und dem Chip 18 sind durch Drahtbonds 23 hergestellt. Figur 4 zeigt in einem Schnittbild weitere Details einer erfindungsgemäßen Anordnung. Die Schichten 12, 13 der Stapelanordnung 11 sind im Bereich der Ausschnitte 14 treppenförmig abgestuft, so daß die Leiterbahnschichten 13 zugänglich sind für Drahtbonds 23 zwischen dem Modul 15 und der Leiterbahnschicht 13. Außerdem ist dargestellt, daß die durch die Ausschnitte 14 geschaffene Kavität mit Vergußmasse 25 ausgefüllt ist.

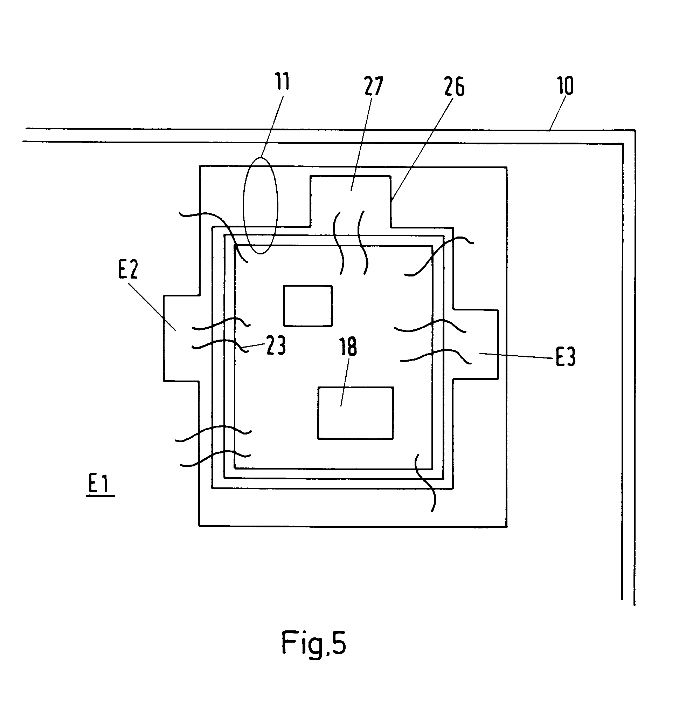

Figur 5 zeigt in einer Draufsicht, daß Anschlußflächen 27 auf den einzelnen Leiterbahnschichten 13 auch durch Ausnehmungen 26 im Stapel 11 geschaffen werden können, die von oben her bis zu der jeweiligen Ebene E1, E2 usw. der Leiterbahnschichten 13 reichen. Anstelle von Ausnehmungen 26 im Stapel 11 können auch zungenförmige Erweiterungen der Leiterbahnschichten 13 vorgesehen werden, die in den durch den Ausschnitt 14 gebildeten Raum ragen. Es versteht sich, daß anstelle von Drahtbondverbindungen auch alternative Verbindungen, z.B. mit Hilfe von Punktschweißen oder Laserschweißen oder durch Klemmkontakte hergestellt werden können.

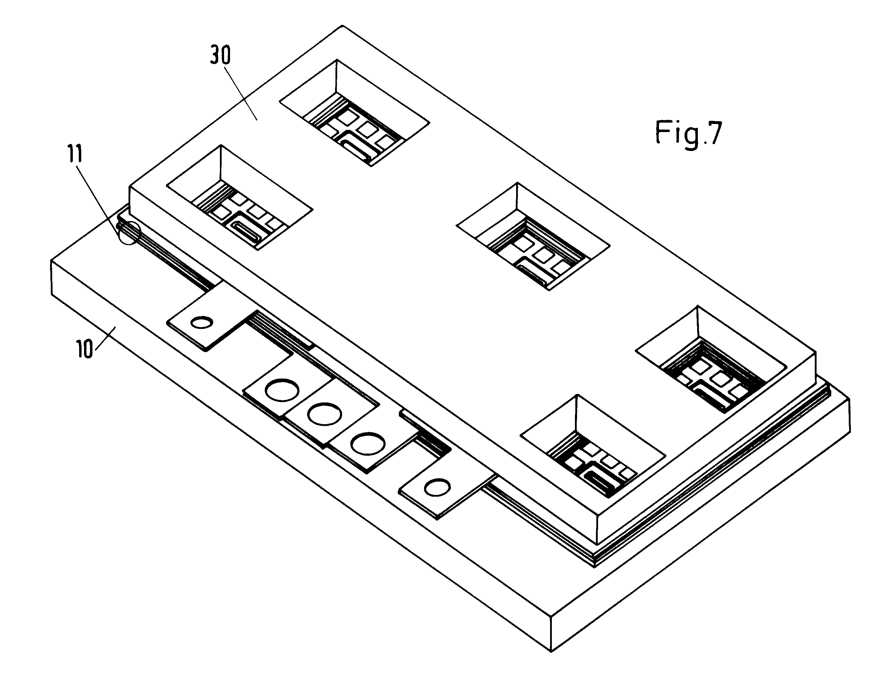

Figur 6 zeigt in einem Schnittbild als alternative thermische, mechanische und elektrische Kontaktierungstechnik eine Klemmkonstruktion, wobei erforderliche Kontakte mit Hilfe von federnden Klemmen 28 und Schrauben 29 hergestellt sind.

Den einzelnen Leiterbahnebenen der in der Figur 1 und 4 gezeigten Stapelanordnung 11 können beliebige Funktionen zugeordnet werden. Es ist zweckmäßig, als oberste Leiterbahnschicht 13 im Stapel 11 ein ruhendes Spannungspotential zuzuordnen. Damit kann eine sehr gute elektrische Abschirmung von elektrischer Störstrahlung nach außen erreicht werden.

Außerdem können durch geeignete Ausführung des Stapels 11 sogenannte Bandleitungen gebildet werden, die zu sehr niedrigen Streuinduktivitäten führen und die Anordnung für hochfrequente Anwendungen anwendbar machen. Die Dimensionierung der Bandleitungen kann nach bekannten Gleichungen erfolgen. Die Induktivität einer solchen Bandleitung ist proportional zum Abstand der Leiterbahnschichten und deren wirksame Länge dividiert durch die Breite der Leiterbahnschichten.

Figur 7 zeigt eine erfindungsgemäße Anordnung, die gegenüber der in Figur 1 gezeigten Anordnung ergänzt ist durch eine auf die Stapelanordnung 11 elektrisch isolierend aufgebrachte, vorzugsweise aufgeklebte Elektronikschicht 30. Die Elektronikschicht 30 kann z.B. in Leiterplattentechnik, Folientechnik oder als Dickschichthybrid ausgeführt sein und die erforderlichen aktiven und passiven Bauelemente zur Realisierung von Steuer- , Regel- oder Schutzfunktionen oder von Ansteuerungen enthalten. Die Elektronikschicht 30 ist ähnlich wie der Stapel 11 ausgeschnitten, so daß elektrische Verbindungen zwischen dem Leistungsteil und der Elektronikschicht, z.B. durch Drahtbonden hergestellt werden können.

### Bezugszeichenliste

1 Elektromotor
2 Gleichrichter
3 Wechselrichter
4 Leistungstransistor
5 Diode
6 Teilbrücke
7 Ansteuerungselektronik
8 Regelelektronik
9 Leistungsteil
10 Trägerplatte
11 Stapelanordnung
12 Isoliermaterialschicht
13 Leiterbahnschicht
14 Ausschnitt
15 Leistungshalbleitermodul
16 Substrat
17 Leiterbahnen
18 Halbleiterchip
19 Kleber
20 Kühlrippe
21 Keramikplatte
22 Kupferfolie
23 Drahtbonds
24 Anschlüsse
25 Vergußmasse
26 Ausnehmung
27 Anschlußfläche
28 federnde Klemme
29 Schraube
30 Elektronikschicht
E1, E2 usw. Leiterbahnschicht-Ebene

## Patentansprüche

1. Hybride leistungselektronische Anordnung mit einem Leistungsteil (9) der nachstehende
Merkmale aufweist:
a) auf einer Trägerplatte (10) ist eine Stapelanordnung (11) mit abwechselnd übereinander angeordneten Isoliermaterialschichten (12) und Leiterbahnschichten (13) befestigt,
b) die Stapelanordnung (11) weist mehrere Ausschnitte (14) auf, in die gehäuselose Leistungshalbleitermodule (15) eingesetzt sind, die aus einem elektrisch isolierenden Substrat (16) mit Leiterbahnen (17) und zumindest Halbleiterchips (18) als Bestükkungselemente bestehen,
c) die Ausschnitte (14) sind treppenförmig gestuft oder es sind durch Ausnehmungen (26) im Stapel (11) oder auf andere Weise Anschlußflächen (27) der Leiterbahnschichten (13) zugänglich gemacht für den Anschluß elektrischer Verbindungsmittel (23) bzw. zur Herstellung elektrischer Verbindungen zwischen den Modulen (15) und Leiterbahnschichten (13) oder zwischen Leiterbahnschichten (13) untereinander.

2. Anordnung nach Anspruch 1, dadurch gekennzeichnet, daß die Trägerplatte (10) als Kühlkörper mit Kühlrippen (20) oder als Flüssigkeitskühler ausgebildet ist.

3. Anordnung nach Anspruch 1 oder 2, dadurch gekennzeichnet, daß auf die Stapelanordnung (11) eine Elektronikschicht (30) aufgebracht ist, in der Steuer-, Regel-, Ansteuerungs- oder Schutzfunktionen realisiert sind, und daß elektrische Verbindungen zwischen dem Leistungsteil (9) und der Elektronikschicht (30) hergestellt sind.

4. Anordnung nach einem der vorstehenden Ansprüche, dadurch gekennzeichnet, daß die Ausschnitte (14) mit Vergußmasse (25) aufgefüllt sind.

5. Anordnung nach einem der vorstehenden Ansprüche, dadurch gekennzeichnet, daß die Trägerplatte (10) aus Metall besteht.

6. Anordnung nach einem der vorstehenden Ansprüche, dadurch gekennzeichnet, daß in der Stapelanordnung (11) durch geeignete geometrische Gestaltung der Leiterbahnen (13) und Isolierschichten (12) niederinduktive Bandleitungen geschaffen sind.

7. Anordnung nach einem der vorstehenden Ansprüche, dadurch gekennzeichnet, daß im Stapel (11) die oberste, also von der Trägerplaqtte (10) am weitestens entfernte Leiterbahnschicht (13) mit einem praktisch gleichbleibenden elektrischen Spannungspotential belegt ist, um eine Abschirmwirkung zu erzielen.

8. Anordnung nach einem der vorstehenden Ansprüche, dadurch gekennzeichnet, daß die Isoliermaterialschichten (12) und Leiterbahnschichten (13) untereinander und mit der Trägerplatte (10) mit Hilfe von Klebstoff befestigt sind.
